# EUROPEAN PATENT APPLICATION

(11) **EP 1 578 143 A2**
(43) Date of publication of application: **21.09.2005**
(21) Application number: 05003128.5
(22) Date of filing: 15.02.2005
(51) Int. Cl.: H04Q 1/10, H05K 7/18

(54) **Improvements introduced in cabinet to house telecommunication equipment**

(30) Priority: 16.03.2004 BR 8400198 U
(71) Applicant: Nilko Metalurgia, Ltda., PR 83325-360 (BR)
(72) Inventor: Huscher, Fraimundo, 679 JD Santa Barbara Curitiba PR (BR)
(74) Representative: Gonzalez Sanchez, German

(57) **Abstract**

"IMPROVEMENTS INTRODUCED IN CABINET TO HOUSE TELECOMMUNICATION EQUIPMENT", comprising, according to the characteristics thereof, the introduction of a proper and specific set of devices and improvements in the strength and safety area in general on the structure of a cabinet (1) to house telecommunication equipment, in order to provide a safe and reliable utilization and safekeeping of different telecommunication equipment in general against non authorized access and bad weather in general, being based on the incorporation and improvement of various proper and specific components in proprietary structures made of metallic material or similar material, whose shape and internal and external arrangement provides the proper housing of telecommunication equipment in general therein and which are properly arranged (fitted and attached) on the basic structure of cabinet (**1**).

## Description

The present patent relates to cabinets for telecommunications in general, more specifically to improvements introduced in cabinets to house telecommunication equipment which, according to the characteristics thereof, possesses as a basic principle the introduction of a proper and specific set of devices and improvements in the strength and safety area in general on the structure of cabinets to house telecommunication equipment, in order to provide a safe and reliable utilization and safekeeping of the latter against vandalism and thefts and bad weather in general, being based on a robust, safe and lasting set of devices. With specific design and shape, easily accessible for a better adaptation and safety for the users, practical handling, functionality, completely safe, and accessible cost and due to their general characteristics and dimensions, are easily adaptable to the cabinet structure, regardless of the place and type of equipment used.

The patent in question is characterized in that it aggregates components and processes in a differentiated concept to meet the several requirements the nature of its use demands, that is, the safekeeping of telecommunication equipment against several different factors. Such concept provides a cabinet to house telecommunication equipment having great efficiency, functionality, strength, durability, versatility and safety due to its excellent technical qualities, thereby providing advantages and improvements to the cabinet as a whole, the general characteristics of which differ from the other shapes and models known in the current state of the art.

The present patent consists in the utilization of modem, versatile, efficient and functional improvements introduced in cabinets to house telecommunication equipment, formed by an assembly of properly incorporated mechanical solutions comprising an assembly of devices and improvements in the strength and safety area, with exclusive design, optimum finish details and proprietary characteristics, which incorporate and improve various proper and specific components in proprietary structures of high durability and strength, made of metallic material or similar material perfectly arranged (fitted and attached) to the basis structure thereof such as an insulating cover on the hood to protect it from sun rays, a differentiated design for the frame profiles as a sealing element, a sealing and electromagnetic shielding assembly as a protection element, a differentiated design for the hinges as a safety element, a differentiated design for the plates external closing systems as a safety and protection element, a differentiated design for the plate structuring as a safety element, a differentiated design for the base profiles acting as a space increasing element, a lock with catch as a safety element, locking of the door rods as a safety element, a differentiated design for the plate composition as a safety element and a connection between cabinets for the passage of cables, so as to form in the cabinet structure with double sheets of aluminum or similar material and plate/plate sandwich-type closing system, and double wall with spacers, a complete and fully safe assembly, whose shape and internal and external arrangement provides the proper housing for several telecommunication equipment, with the specific function of ensuring its integrity and that of the pieces of equipment housed thereof against vandalism, non-authorized access and bad weather when installed in public ways or the like.

Through the present improvements introduced in cabinets to house telecommunication equipment, destined to improve and guarantee their safekeeping against vandalism, theft, non authorized access and the like, as well as to ensure their endurance against bad weather, last-generation technological solutions are incorporated thereto, thereby providing an excellent safety, strength, durability and quality level to the entire safekeeping and usage process of cabinets to house telecommunication equipment.

The present improvements are based on the utilization of strong and safe devices comprising components and processes in a differentiated concept, thereby allowing to solve some of the main inconveniences of the other shapes and models of cabinets to house telecommunication equipment in general, as known in the current state of the art, which are located in a work range wherein there is no proper and safe protection against non authorized access and bad weather and whose shapes and/or products are obsolete and handcrafted locally based in adaptations, which causes fragility and difficult maintenance low strength and durability, or else they have a large structure, which means high costs, difficult and slow installation and the need of high skilled labor.

The objects, advantages and other important characteristics of the patent in question can be more easily understood when read jointly with the appended drawings, wherein:

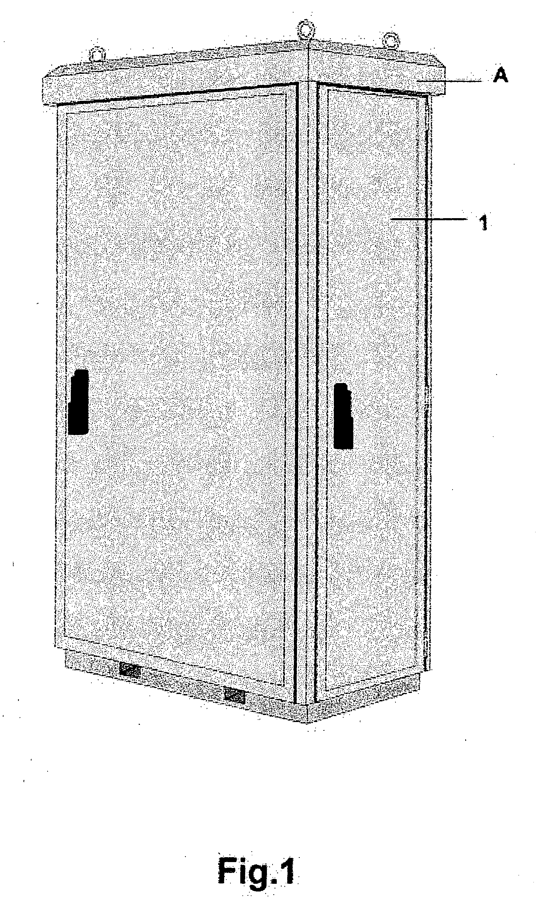

Figure 1 is a perspective view of cabinet to house telecommunication equipment.

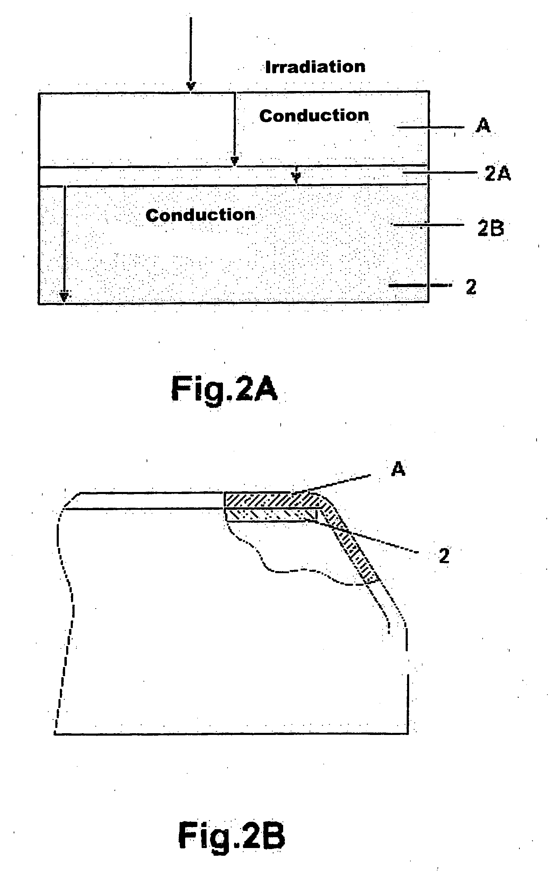

Figure 2A is a schematic view of the composition of the hood of cabinet to house telecommunication equipment including the insulating cover.
Figure 2B is a cross-sectional view of the composition of the hood of cabinet to house telecommunication equipment including the insulating cover.

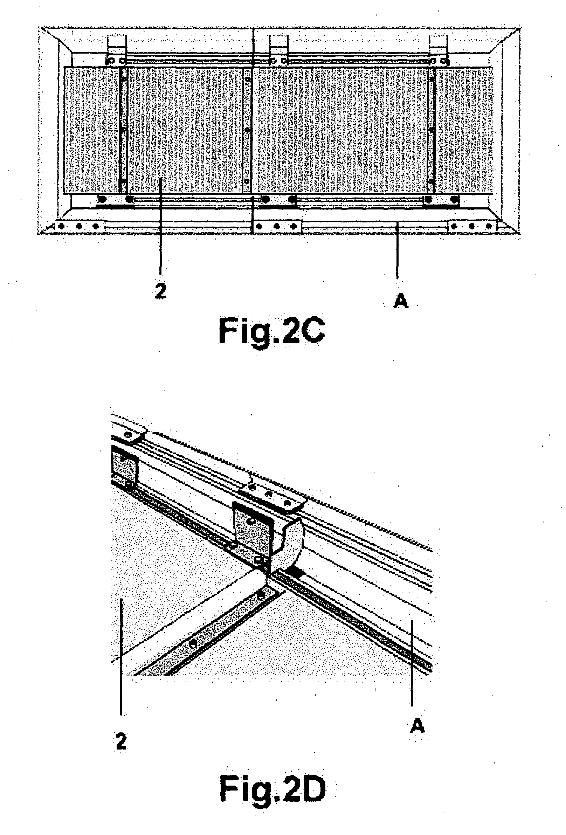

Figure 2C is a top view of the composition of the hood of cabinet to house telecommunication equipment including the insulating cover.
Figure 2D is a detailed perspective view of the composition of the hood of cabinet to house telecommunication equipment including the insulating cover.

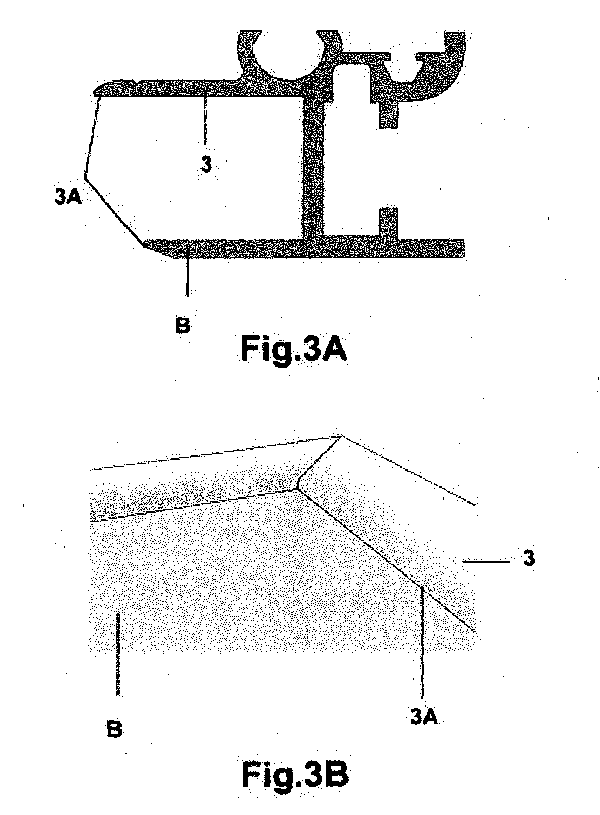

Figure 3A is a cross-sectional view of the differentiated design for the frame profiles introduced in cabinet to house telecommunication equipment.
Figure 3B is a detailed perspective view of the differentiated design for the frame profiles introduced in cabinet to house telecommunication equipment.

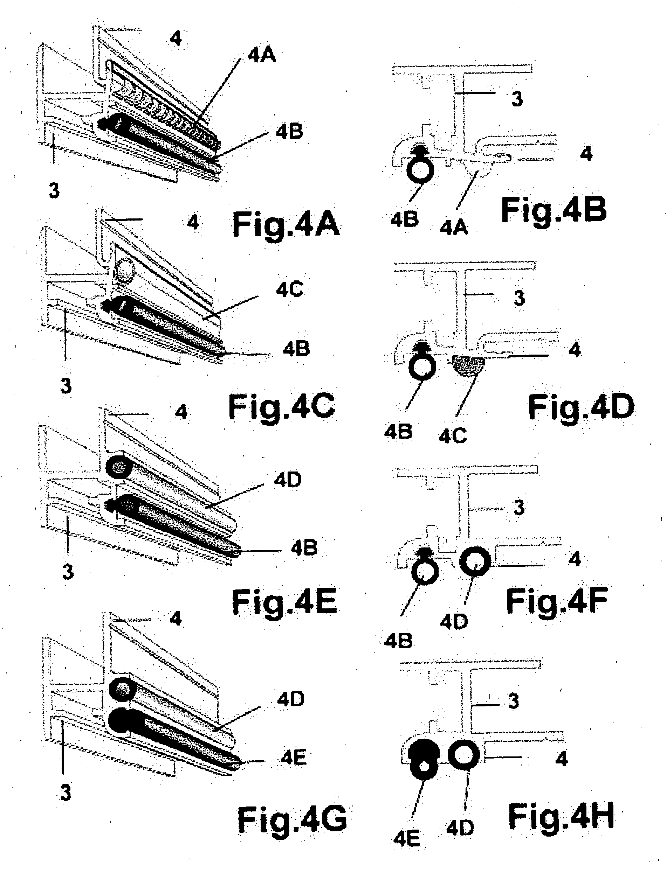

Figure 4A is a perspective view of the sealing and electromagnetic shielding assembly in high-frequency configuration and solid EPDM rubber introduced in cabinet to house telecommunication equipment.
Figure 4B is a cross-sectional view of the sealing electromagnetic shielding assembly in high-frequency configuration and solid EPDM rubber introduced in cabinet to house telecommunication equipment.
Figure 4C is a perspective view of the sealing and electromagnetic shielding assembly in medium frequency configuration and solid EPDM rubber introduced in cabinet to house telecommunication equipment.
Figure 4D is a cross-sectional view of the sealing and electromagnetic shielding assembly in medium frequency configuration and solid EPDM rubber introduced in cabinet to house telecommunication equipment.
Figure 4E is a perspective view of the sealing and electromagnetic shielding assembly in low-frequency configuration and solid EPDM rubber introduced in cabinet to house telecommunication equipment.
Figure 4F is a cross-sectional view of the sealing and electromagnetic shielding assembly in low-frequency configuration and solid EPDM rubber introduced in cabinet to house telecommunication equipment.
Figure 4G is a perspective view of the sealing and electromagnetic shielding assembly in low-frequency configuration and viscous EPDM rubber introduced in cabinet to house telecommunication equipment.
Figure 4H is a cross-sectional view of the sealing and electromagnetic shielding assembly in low-frequency configuration and viscous EPDM rubber introduced in cabinet to house telecommunication equipment.

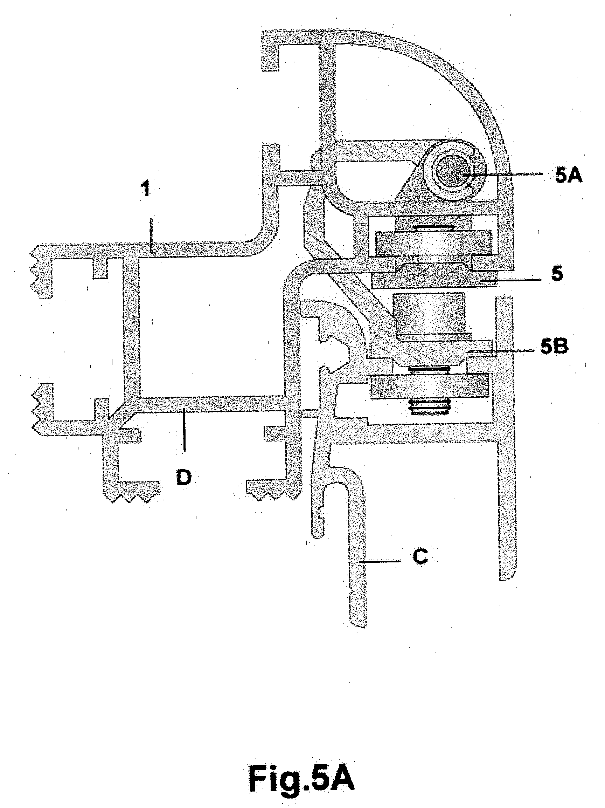

Figure 5A is a cross-sectional view of the differentiated design for the hinges of cabinet to house telecommunication equipment.

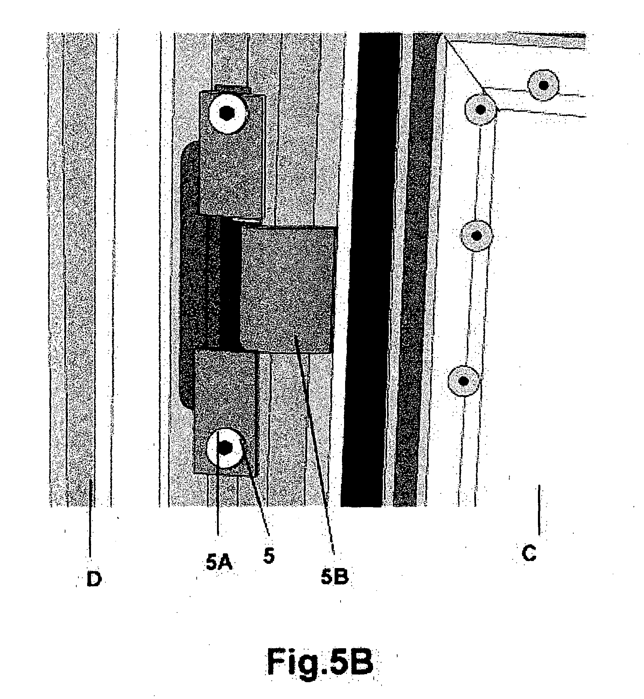

Figure 5B is a perspective view of the differentiated design for the hinges introduced in cabinet to house telecommunication equipment.

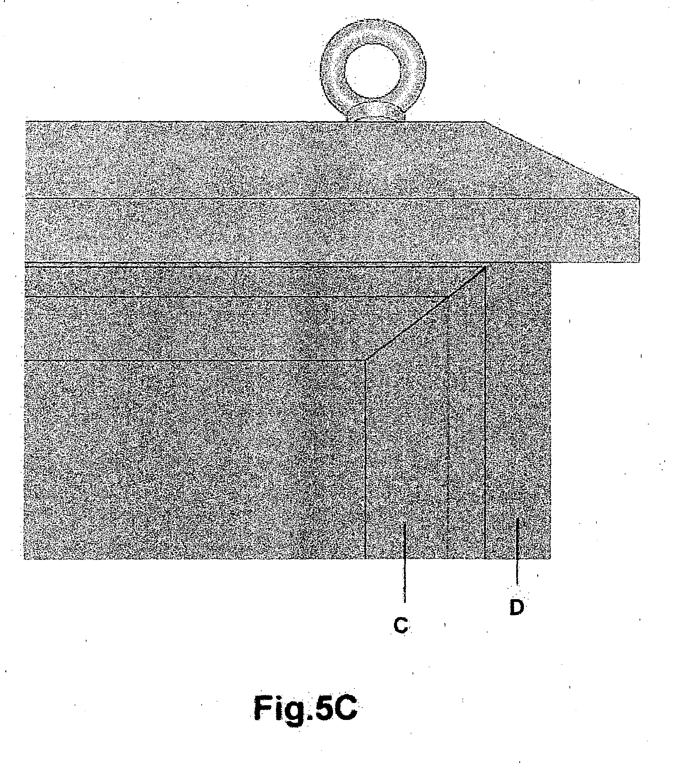

Figure 5C is' a detailed perspective view of cabinet to house telecommunication equipment showing the area of connection of the door and vertical column and the non-visualization of the hinges in the present differentiated design.

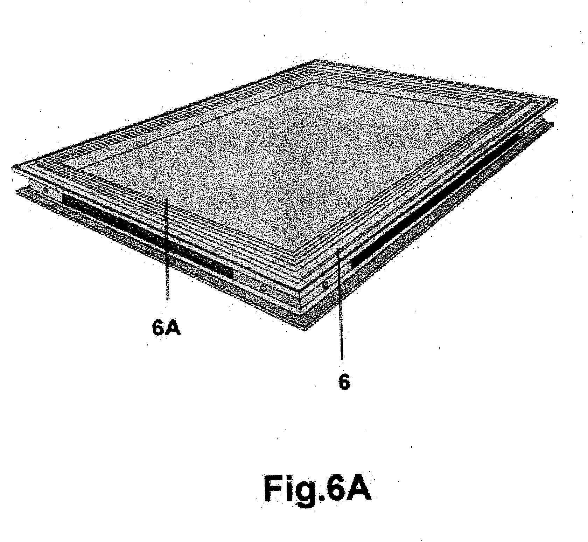

Figure 6A is a perspective view of the differentiated design for the plates external closing systems introduced in cabinet to house telecommunication equipment.

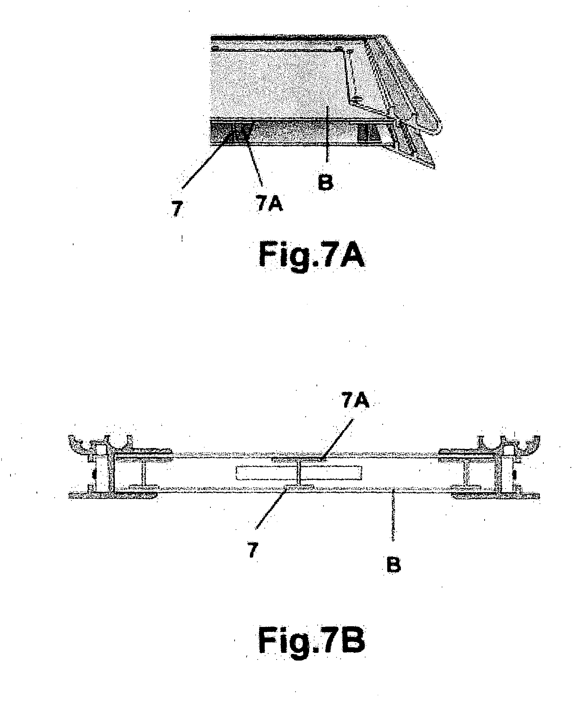

Figure 7A is a detailed perspective view of the differentiated design for the plate structuring introduced in cabinet to house telecommunication equipment.
Figure 7B is a cross-sectional view of the differentiated design for the plate structuring introduced in cabinet to house telecommunication equipment.

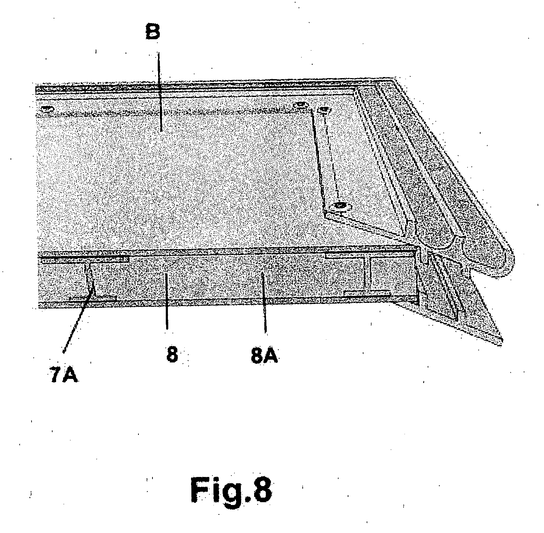

Figure 8 is a detailed perspective view of the differentiated design for the plate composition introduced in cabinet to house telecommunication equipment.

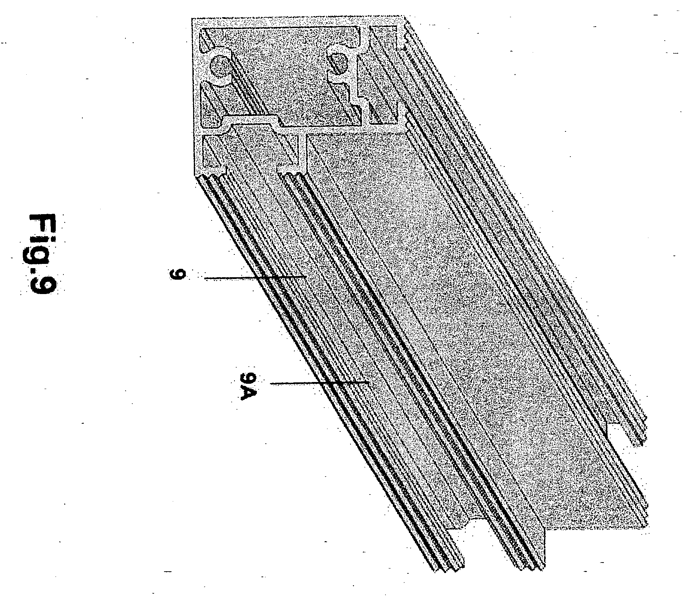

Figure 9 is a perspective view of the differentiated design for the base profiles introduced in cabinet to house telecommunication equipment.

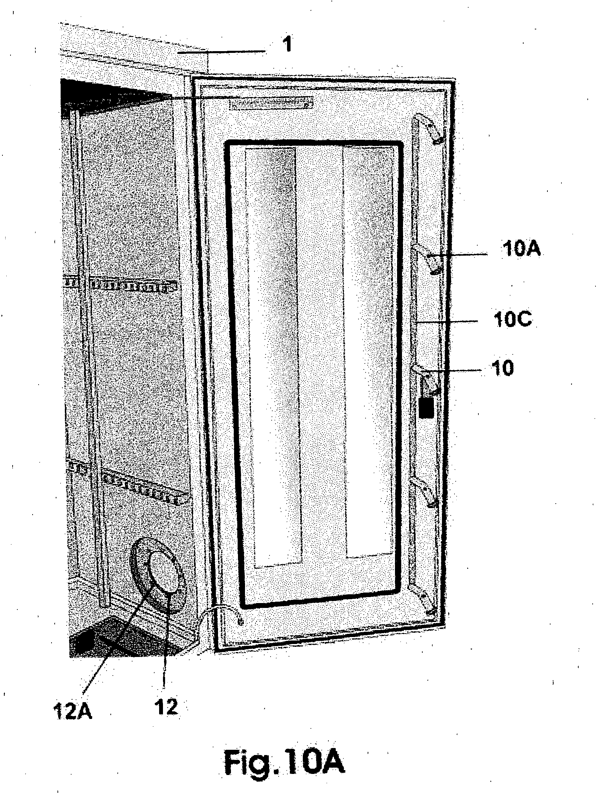

Figure 10A is a perspective view of the inner side of the door of cabinet to house telecommunication equipment, showing the assembly locks with catches.

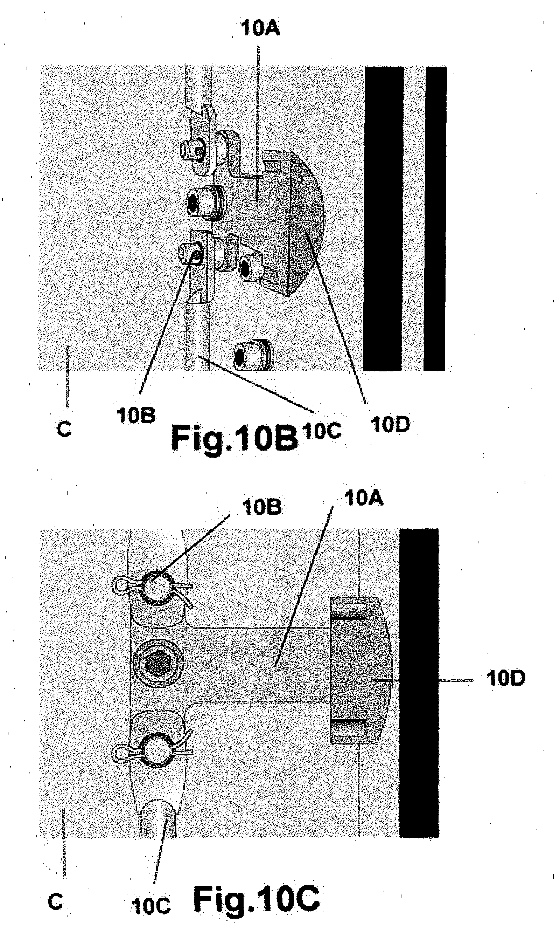

Figure 10B is a perspective view of the lock with catch of cabinet to house telecommunication equipment.
Figure 10C is a front view of the lock with catch of cabinet to house telecommunication equipment.

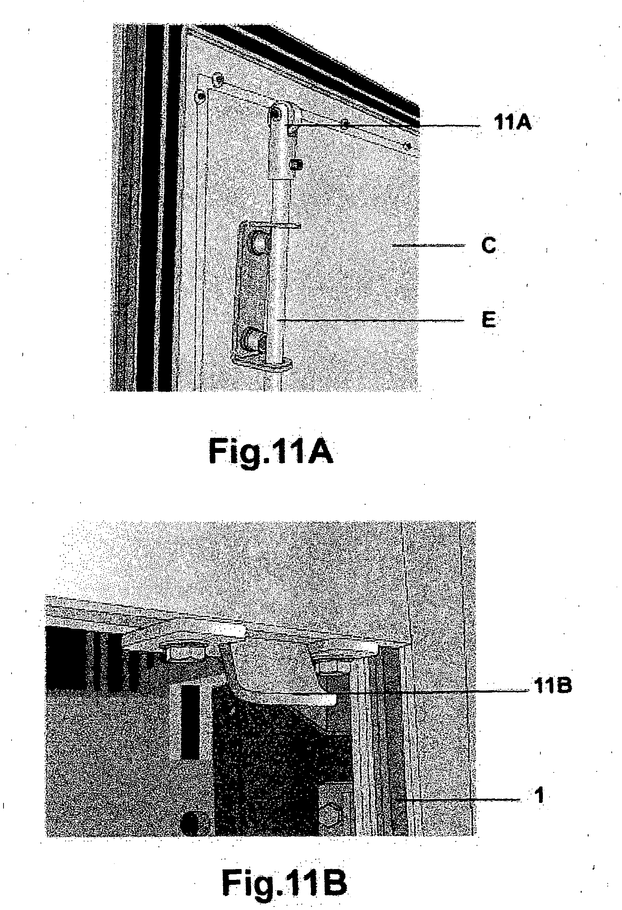

Figure 11A is a perspective view of the pulley for the locking of the door rods of cabinet to house telecommunication equipment.
Figure 11B is a perspective view of the slope for the locking of the door rods of cabinet to house telecommunication equipment.

As can be inferred from the appended drawings that illustrate and integrate the present descriptive report of the patent for utility model of "Improvements Introduced in Cabinets to House Telecommunication Equipment", the appended figures show the same in a general manner, possessing a set of devices and improvements in the strength and safety area comprising and improving various proper and specific components in proprietary structures of high strength and durability, made of metallic material or similar material, the shape and internal and external arrangement of which providing the perfect housing of different telecommunication equipment in general, properly arranged to the basis structure of cabinet (1) made of double aluminum plates or similar material with a plate/plate sandwich-type closing system and a double wall with spacers, the set of devices and improvements comprise an insulating cover (2) on the hood (A), a differentiated design for the frame profiles (3), a sealing and electromagnetic shielding assembly (4), a differentiated design for the hinges (5), a differentiated design for the plates external closing systems (6), a differentiated design for the plate structuring (7), a differentiated design for the plate composition (8), a differentiated design for the base profiles (9), a lock with catch (10), locking for the door rods (11) and a connection between cabinets (12).

The insulating cover (2) having a general rectangular shape and being symmetrically and parallelaly arranged underneath and along the inner periphery of the outer plate of hood (A) is made up by a foil (2A) in aluminum or similar material arranged underneath the inner face of the outer plate of hood (A) and polyethylene foam (2B) or similar material arranged underneath the foil (2A), being the function of the assembly to minimize the effects of sun rays on the inside of cabinets (1), the insulating cover (2) is always applied near the outer plate of hood (A), so that the heat irradiated by the sun is blocked before it contacts the inside of cabinet (1).

The differentiated design introduced in the frame profiles (3) is formed by a slight rounding off (3A) symmetrically arranged along the edges thereof with the function of preventing the formation of bubbles on the paint and the build up of salt in the area between the frame profile (3) and the sandwich plates (B), as well as a general improvement on the aesthetic side of the assembly as a whole, having the frame profiles (3) making part of the doors, side closing panels and rear closing panels the function of framing the sandwich plates (B) and the spacers.

The sealing and electromagnetic shielding assembly (4) is formed by an IP55 rubber coating (dust and moisture) and an electromagnetic shielding in three models horizontally and symmetrically arranged side by side and along the periphery of the frame profile (3), each model of IP55 rubber coating (dust and moisture) chosen in terms of the type of frame profile (3) employed and each model of electromagnetic shielding used for a specific purpose directly dependant on the analysis of information about the product it is to be applied on, in this case the assemblies being formed by a pair of high frequency shielding (4A) and 60Shore A solid EPDM rubber (4B), a pair of medium frequency shielding (4C) and 60Shore A solid EPDM rubber (4B), a pair of low frequency shielding (4D) and 60Shore A solid EPDM rubber (4B) and a pair of low frequency shielding (4D) and 15Shore A viscous EPDM rubber (4E).

The differentiated design introduced in the inner hinges (5), which are made of stainless steel or similar material, vertically and symmetrically arranged along the entire lateral end of the door (C) of cabinet (1) and fastening it to the vertical column (D) thereof and made up by an attaching body (5A) attached to the vertical column (D) and a catch (5B) attached to the door (C), creating a design that fully embeds the hiriges in the door (C) and cabinet (1), in such a way that makes it impossible to visualize any detail of the inner hinge (5) through the external side of cabinet (1), having the assembly an opening angle of a hundred and twenty degrees with the function of improving the protection against vandalism and providing a better appearance to the cabinet (1) structure.

The differentiated design introduced in the plates external closing systems (6) (doors and closing systems) is formed by a gluing process with specific sealant (6) symmetrically arranged along the closing systems so as to form one hundred percent glued external closing systems (6) and with the function of improving the strength of the sandwich plates (B) as compared to the riveted sandwich plates (B), so as to eliminate the risk of damage to the assembly paint and any relative motion between the sandwich plate (B) components, speed up the installation process and withhold temperatures between minus fifty degrees Celsius and a hundred and ten degrees Celsius.

The differentiated design introduced in the plate structuring' (7) is formed by an assembly of inner profiles (7A) having general I-section shapes symmetrically arranged lengthwise the sandwich plates (B), with the function of reinforcement therein, instead of the inner profiles having general rectangular-section shapes.

The differentiated design introduced in the plate composition (8) is formed by an insulating plate (8A) having a general parallelepipedal shape, made of a thermal insulation material such as insulating cover, polystyrene, expanded polyurethane, mineral wool or similar material symmetrically attached along the inner periphery of the sandwich plates (B), with the function of creating a closing substract of the sandwich plates (B).

The differentiated design introduced in the base profiles (9) is formed by a base profile (9A) having a general shape similar to a "T" and possessing a lower height and a fairly simplified cross section, with the main function of increasing the useful space of cabinet (1), instead of a cross section with a general shape similar to a rectangle.

The lock with catch (10) is formed by an assembly of catches (10A) each having a general shape similar to a "T" and possessing in vertical alignment two engaging pins (10B) on the inner end to engage the ends of the link rods (10C) and a protecting cover (10D) made of plastic or similar material, having a trapezoidal shape fully covering the outer end of the catch, with the catches (10A) horizontally and symmetrically spaced by the link rods (10C) along the inner periphery of the door (C) creating a lock with multiple catches (10), the assembly possessing the function of increasing the number of locking points of the doors (C) of cabinet (1) to avoid damage to the cabinet (1) structure, respectively, multiple catches and catch protection.

The locking of the door rods (11) is formed by two pulleys (11) made of nylon or similar material each vertically and symmetrically arranged in one of the ends of the door (E) rod, vertically arranged along the inner periphery of the door (C), and two corner plates (11B) having a rectangular shape with a small catch, each horizontally arranged on the inner side of the upper and lower faces, respectively, of the front holding structure, at the same alignment of the upper and lower end of the door (E) rod, being the pulley (11A) in direct contact with the corner plate (11B) so as the door locking pressure (C) is given when the lock is triggered.

A connection between cabinets (12) is required when using modular cabinets and it is formed by a direct system of specific connections (12A), having general circular shapes symmetrically arranged on the sides of cabinet (1), so as to properly interconnect the latter, that is, with the function of interconnecting cabinets (1) and allowing the passage of the most varied types of cables, as well as protecting against the penetration of dust and moisture therein, since when making use of the concept of modular cabinets the connection between the several cabinets (1) is required, usually assembled side by side.

The improvements introduced in cabinet to house telecommunication equipment, as based on their general and individual concepts, possess separate operations, in order to guarantee the total integrity and safety of cabinets (1) and the electronic equipment contained thereof, as shown on the appended figures. Those improvements have been designed to provide full safety against cabinet (1) non authorized access and bad weather; their principles comprising security, strength and durability aspects.

The components of the improvements introduced in cabinet to house telecommunication equipment are fully fitted and attached, are quickly installed, do not present any distorting or breakable parts, are highly resistant and completely safe. After fitted and attached to the structure of cabinet (1), the components are locked and attached, thus preventing them from getting loose or breaking when in use, thus making the assembly fully available for housing telecommunication equipment in general. The cabinet (1), therefore, can be easily used without worries of any nature as regarding its durability and safety.

As their structures are made of metallic material or similar material with equal or higher lightness and strength, the improvements introduced in cabinet to house telecommunication equipment and the components and accessories thereof, are rustproof and waterproof, have a high level or durability and strength, provide great safety and, when used in the cabinets (1), do not present any risks of fatigue of their structures and the equipment contained thereto.

For all of the above, this is an invention that will be well received by the companies manufacturing and making use of cabinets to house telecommunication equipment in general, since the present improvements introduced in cabinets to house telecommunication equipment present several advantages, such as: great safety, reliability and agility in applications and uses; great strength and durability, since this is a high technology product; lower or no wear of the assembly as a whole; greater comfort, facility and safety to the users; fully accessible costs, which provides an optimum cost/benefit ratio; practical and safe usage by any users; practical maintenance; great mobility and flexibility allowing an easy transportation to any place; modem design; practical and safe assembly and installation; general arrangements that do not upset the cabinet normal operation and take up small room; great resistance to bad weather; full access control; greater space on the inside of cabinet; and the certainty of always having a cabinet (1) to house telecommunication equipment that fully meets the basic , requirements for its application, the area-related standards and legislations, and the basic items of safety, durability and practical handling.

For all of the above, the improvements introduced in cabinet to house telecommunication equipment can be classified as a fully versatile, efficient, practical and safe set of means for companies making use of cabinets to house telecommunication equipment in general against non authorized access and bad weather, in any public place, such as at the base of antennas, or public ways and installations in general, regardless of the general characteristics thereof, they are also easy to install and to handle, and have great strength and excellent characteristics; the sizes and dimensions may vary, depending on the use needs.

## Claims

1. "IMPROVEMENTS INTRODUCED IN CABINET TO HOUSE TELECOMMUNICATION EQUIPMENT", **characterized in that** it comprises a set of devices and improvements in the strength and safety area comprising and improving various proper and specific components in proprietary structures, made of metallic material or similar material, shape and internal and external arrangement providing the housing of different telecommunication equipment in general on the cabinet (1) structure and that are properly arranged (fitted and attached) on the basic structure of cabinet (1) with double sheets of aluminum or similar material and plate/plate sandwich-type closing system and double wall with spacers, being this set of devices and improvements comprised by an insulating cover (2) on the hood (A), a differentiated design for the frame profiles (3), a sealing and electromagnetic shielding assembly (4), a differentiated design for the hinges (5), a differentiated design for the plates external closing systems (6), a differentiated design for the plate structuring (7), a differentiated design for the plate composition (8), a differentiated design for the base profiles (9), locks with catch (10), locking of the door rods (11) and a connection between cabinets (12).

2. "IMPROVEMENTS INTRODUCED IN CABINET TO HOUSE TELECOMMUNICATION EQUIPMENT", in accordance with claim 1, **characterized in that** it contains an insulating cover (2) having a general rectangular shape symmetrically and parallelaly arranged underneath and along the inner periphery of the outer plate of hood (A) formed by a foil (2A) in aluminum or similar material arranged underneath the inner face of the outer plate of hood (A) and polyethylene foam (2B) or similar material arranged underneath the foil (2A).

3. "IMPROVEMENTS INTRODUCED IN CABINET TO HOUSE TELECOMMUNICATION EQUIPMENT", in accordance with claim 1, **characterized in that** it contains a differentiated design for the frame profiles (3) formed by a slight rounding off (3A) symmetrically arranged along the edges thereof, with the frame profiles (3) making part of the doors, side closing panels and rear closing panels framing the sandwich plates (B) and the spacers.

4. "IMPROVEMENTS INTRODUCED IN CABINET TO HOUSE TELECOMMUNICATION EQUIPMENT", in accordance with claim 1, **characterized in that** it contains a sealing and electromagnetic shielding assembly (4) formed by an IP55 rubber coating (dust and moisture) and an electromagnetic shielding in three models horizontally and symmetrically arranged side by side and along the periphery of the frame profile (3), each model of IP55 rubber coating (dust and moisture) chosen in terms of the type of frame profile (3) used and each model of electromagnetic shielding used for a specific purpose directly dependant on the analysis of information about the product it is to be applied on, in this case the assemblies being formed by a pair of high frequency shielding (4A) and 60Shore A solid EPDM rubber (4B), a pair of medium frequency shielding (4C) and 60Shore A solid EPDM rubber (4B), a pair of low frequency shielding (4D) and 60Shore A solid EPDM rubber (4B) and a pair of low frequency shielding (4D) and 15Shore A viscous EPDM rubber (4E).

5. "IMPROVEMENTS INTRODUCED IN CABINET TO HOUSE TELECOMMUNICATION EQUIPMENT", in accordance with claim 1, **characterized in that** it contains a differentiated design for the inner hinges (5), made of stainless steel or similar material vertically and symmetrically arranged along the entire lateral end of the door (C) of cabinet (1) and fastening it to the vertical column (D) thereof and made up by an attaching body (5A) attached to the vertical column (D) and the catch (5B) attached to the door (C), creating a design that fully embeds the hinges in the door (C) and cabinet (1), in such a way that makes it impossible to visualize any detail of the inner hinge (5) through the external side of cabinet having the assembly an opening angle of a hundred and twenty degrees.

6. "IMPROVEMENTS INTRODUCED IN CABINET TO HOUSE TELECOMMUNICATION EQUIPMENT", in accordance with claim 1, **characterized in that** it contains a differentiated design for the plates external closing systems (6) (doors and closing systems) formed by a gluing process with specific sealant (6) symmetrically arranged along the closing systems so as to form one hundred percent glued external closing systems (6).

7. "IMPROVEMENTS INTRODUCED IN CABINET TO HOUSE TELECOMMUNICATION EQUIPMENT", in accordance with claim 1, **characterized in that** it contains a differentiated design for the plate structuring (7) formed by an assembly of inner profiles (7A) having general I-section shapes symmetrically arranged lengthwise the sandwich plates (B).

8. "IMPROVEMENTS INTRODUCED IN CABINET TO HOUSE TELECOMMUNICATION EQUIPMENT", in accordance with claim 1, **characterized in that** it contains a differentiated design for the plate composition (8) formed by an insulating plate (8A) having a general parallelepipedal shape made of a thermal insulation material such as insulating cover, polystyrene, expanded polyurethane, mineral wool or similar material symmetrically attached along the inner periphery of the sandwich plates (B).

9. "IMPROVEMENTS INTRODUCED IN CABINET TO HOUSE TELECOMMUNICATION EQUIPMENT", in accordance with claim 1, ' **characterized in that** it contains a differentiated design for the base profiles (9) formed by a base profile (9A) having a general shape similar to a "T" and possessing a lower height and a fairly simplified cross section.

10. "IMPROVEMENTS INTRODUCED IN CABINET TO HOUSE TELECOMMUNICATION EQUIPMENT", in accordance with claim 1, **characterized in that** it contains a lock with a catch (10) formed by an assembly of catches (10A) each having a general shape similar to a "T" and possessing in vertical alignment two engaging pins (10B) on the inner end to engage the ends of the link rods (10C) and a protecting cover (10D) in plastic or similar material having a trapezoidal shape fully covering the outer end of the catch, being the catches (10A) horizontally and symmetrically spaced by the link rods (10C) along the inner periphery of the door (C) thus creating a lock with multiple catches (10).

11. "IMPROVEMENTS INTRODUCED IN CABINET TO HOUSE TELECOMMUNICATION EQUIPMENT", in accordance with claim 1, **characterized in that** it contains a locking of the door rods (11) formed by two pulleys (11) made of nylon or similar material each vertically and symmetrically arranged in one of the ends of the door (E) rod, vertically arranged along the inner periphery of the door (C), and two corner plates (11B) having a rectangular shape with a small catch each horizontally arranged on the inner side of the upper and lower faces, respectively, of the front holding structure, at the same alignment of the upper and lower end of the door (E) rod, being the pulley (11A) in direct contact with the corner plate (11B).

12. "IMPROVEMENTS INTRODUCED IN CABINET, TO HOUSE TELECOMMUNICATION EQUIPMENT", in accordance with claim 1, **characterized in that** it presents a connection between cabinets (12) required when using modular cabinets, assembled side by side, and formed by a direct system of specific connections (12A) having a general circular shape symmetrically arranged on the sides of cabinet (1), so as to properly interconnect the latter and allow the passage of the most varied types of cables, as well as the protection against the penetration of dust and moisture therein.
